(19) Europäisches Patentamt
European Patent Office
Office européen des brevets

(11) Publication number: **0 220 661 B1**

(12) # EUROPEAN PATENT SPECIFICATION

(45) Date of publication of patent specification :
06.02.91 Bulletin 91/06

(51) Int. Cl.⁵: **H05K 13/02, B65H 9/10,**
**B32B 31/10**

(21) Application number: **86114569.6**

(22) Date of filing: **21.10.86**

(54) Apparatus for conveying a base as of a printed circuit board.

(30) Priority: **22.10.85 JP 236860/85**
**22.10.85 JP 236861/85**

(43) Date of publication of application:
**06.05.87 Bulletin 87/19**

(45) Publication of the grant of the patent:
**06.02.91 Bulletin 91/06**

(84) Designated Contracting States:
**CH DE FR GB IT LI SE**

(56) References cited:
**CH-A- 551 864**
**GB-A- 2 054 537**
**US-A- 3 858 870**

(73) Proprietor: **SOMAR CORPORATION**
**11-2, Ginza 4-chome Chuo-ku**
**Tokyo 104 (JP)**

(72) Inventor: **Sumi, Shigeo**
**8-11, Ayase**
**Hasuda-shi Saitama (JP)**
Inventor: **Matsuo, Takao**
**17-3-103, Karatodai 4-chome Kita-ku**
**Kobe-shi Hyogo (JP)**

(74) Representative: **Boeters, Hans Dietrich, Dr. et al**
**Boeters & Bauer Bereiteranger 15**
**D-8000 München 90 (DE)**

## Description

## BACKGROUND OF THE INVENTION

This invention relates to an apparatus for conveying a base and more particularly to a technique effectively applicable to an apparatus for conveying a base for use in a film laminator.

Printed circuit boards for use in electronic equipment e.g., computers are such that a copper wiring or the like having a predetermined pattern is formed on the surface of an insulating base.

A printed circuit board of that sort is made in the following steps of process. A laminate consisting of a photosensitive resin layer (photoresist) and a translucent resin film (protective film) for protecting the photosensitive resin layer is bonded onto a conductive layer provided on an insulating base through thermocompression bonding. The thermocompression bonding of laminates is conducted by a laminator on a mass-production basis. Then a wiring pattern film is superposed on the laminate, and the photosensitive resin layer is exposed to light for a predetermined period of time through the wiring pattern film and the translucent resin film. The photosensitive resin layer thus exposed to light is developed to form an etching mask pattern after the translucent resin film is peeled off by a peeling device. Unnecessary portions of the conductive layer are subsequently removed by etching and the remaining photosensitive resin layer is also removed to form a printed circuit board having a predetermined wiring pattern.

During the process of manufacturing the printed circuit board, there is needless to say required the step of forming a laminate consisting of a photosensitive resin layer and a translucent resin film on an insulating base having conductive layers formed on both sides thereof through thermocompression bonding.

A roll of laminate continuously wound on a supply roller of a film laminator is pulled out and then cut into pieces corresponding in dimensions to the base to provide a laminate to be bonded thereto.

An apparatus for conveying the base to the thermocompression roller position is equipped with a plurality of rotary means formed with a plurality of discoidal rollers (pinch rollers), which are rotated to move the base. When the base approaches thermocompression rollers, fixed guide members guide the base crosswise toward the centerline in the conveyance direction and cause the thermocompression rollers to hold the base therebetween.

However, the problem is that, when a thin base that has been bent crosswise is conveyed, the guide members are incapable of setting the centerline of the base accurately to the centerline in the conveyance direction of the apparatus for conveying a base.

Also, even if the base is set exactly along the centerline of the conveyance path, there is still a fear that the set position of the base would be offset from a thin film to be laminated thereon. In this case, it would be very difficult to correct the offset amount therebetween.

An apparatus for aligning thin sheets is known from GB-A-2 054 537 in the form of a jogging apparatus for jogging paper sheets that are consecutively fed to the plate cylinder of an offset printing press.

Accordingly the invention as claimed solves the problem of aligning thin bases as e.g. such of printed cicuits by other means.

The crosswise base guide used in the present invention allows to be adjusted to the breadth of each base arrival of which is sensed by the respective position detecting sensor means. Accordingly the bases to be aligned are individually pinched in a practical statical manner between the guide members of either side very similar to being gripped by a hand.

In a typical example the bases are conveyed by conveyor rollers. When a base is conveyed the base position detection sensor means detects arrival of the base in a predetermined position and produces a detection signal for making the crosswise base guide start operation. I.e. the two guide members of the crosswise base guide start approaching each other from a relatively spaced position. The base breadth detecting sensor means then detects both sides of the base to produce a detection signal for making the two guide members stop approaching. Thus the base can be conveyed without bending up to e.g. the aforementioned thermocompression rollers of a laminator in such a state that the center line in the conveyance direction of the base coincides with the center line in the conveyance direction of the conveying apparatus itself.

Referring now to the drawings, a description will be given of an embodiment of the present invention applied to an apparatus for conveying a base for a film laminator for bonding a laminate consisting of a photosensitive resin layer and a translucent resin film onto a printed circuit board through thermocompression bonding.

## BRIEF DESCRIPTION OF THE DRAWINGS

Fig. 1 is a perspective structural view of an apparatus according to the present invention ;

Fig. 2 is a schematic structural view of a film laminator related to an apparatus according to the present invention ;

Fig. 3 is a sectional view taken on line Y-Y of Fig. 1 ;

Fig. 4 is a perspectiae structural view of a crosswise base guide of Fig. 3 ;

Fig.5 is a side view showing in more detail the construction and arrangement of base breadth detecting sensors, a holding member and a base support member as principally shown in Fig. 1 ; and

Fig. 6 is a side view more completely showing the construction of the base support member of Figs 1 and 5.

## DETAILED DESCRIPTION OF THE PREFERRED EMBODIMENTS

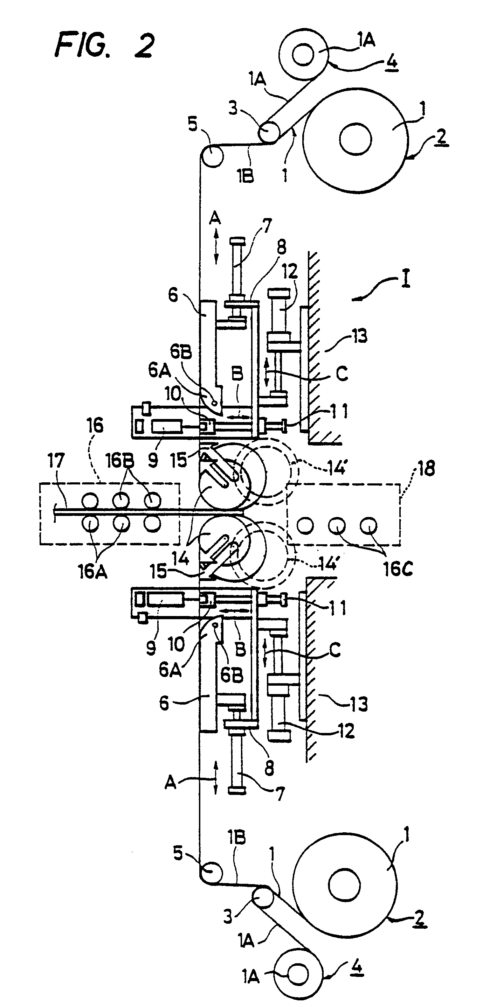

The film laminator I shown in Fig. 2 is designed to apply similar laminates of the kind described to both sides of a base, the base having conductive layers on both sides, accordingly.

In the film laminator I shown in Fig. 2, a three-layer laminate 1 consisting of a photosensitive resin layer and two translucent resin films is continuously drawn from each of an upper and a lower supply roller 2. The laminate 1 drawn from the suply roller 2 is separated by a peeling roller 3 into a translucent resin film (protective film) 1A and a remaining laminate 1B composed of the photosensitive resin layer with one side exposed (adhesive surface) and of the other translucent resin film. The translucent resin film 1A thus separated is wound on a take-up roller 4.

The front end of the laminate 1B in the supply direction.is sucked to a main vacuum plate 6 after passing a tension roller 5. The main vacuum plate 6 is supported by a frame 8 through an air cylinder 7 its position being thus variable in the direction of arrow A. An arcuate portion 6A at the front end of the main vacuum plate 6 contains a heater 6B and serves to attack the front end of the laminate 1B onto the conductive layer of the base 17 through thermocompression bonding. A rotary cutter 9 installed close to the arcuate portion 6A is used to cut the continuous laminate 1B into pieces corresponding in dimensions to the bases 17.

An auxiliary vacuum plate 10 assisting to have the front end of the laminate 1B thus cut off sucked to the arcuate portion 6A is positioned opposite to the rotary cutter 9. The auxiliary vacuum plate 10 is supported by the frame 8 through an air cylinder 11 its position being thus variable in the direction of arrow B. The frame 8 for supporting the main vacuum plate 6 and the auxiliary vacuum plate 10 is itself supported by a frame 13 of the laminator proper through an air cylinder 12 its position being thus variable in the direction of arrow C.

The laminate 1B whose front end is provisionally attacked by the arcuate portion 6A to the conductive layer of the base 17 is then thoroughly bonded by a thermocompression roller 14. The thermocompression roller 14 at first bonds the front end of the laminate 1B onto the arcuate portion 6A through thermocompression bonding and then moves from a position shown by the dotted line marked with numeral 14' to the position shown by a solid line. The rear end of the laminate 1B cut to size by the rotary cutter 9 is guided by a triangular rotary vacuum plate 15 to prevent it from wrinkling and before it is bonded by the thermocompression roller 14.

In the film laminator I so far described the base 17 is supplied and conveyed by an apparatus 16 of the present invention comprising conveyor rollers 16A and pressing rollers 16B. The base 17 with the laminate 1B bonded thereto is carried out of the laminator I by a base discharging device 18 including conveyor rollers 16C.

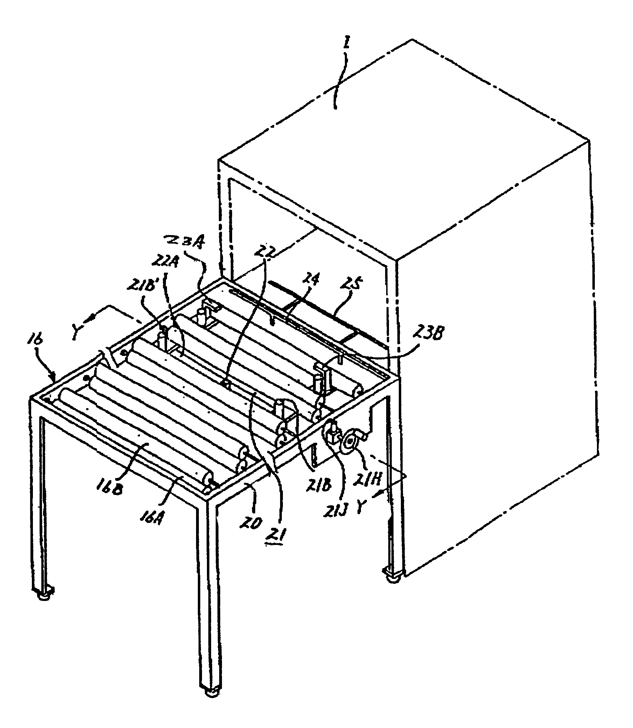

The apparatus 16 is coupled to the laminator I in the manner shown in Fig. 1. Each conveyor roller 16A is formed with a (solid or hollow : preferably hollow) fiber-reinforced plastic columnar member and a plurality of conveyor rollers 16 A are rotatably fitted to a frame 20 of the apparatus 16. The conveyor rollers 16A are arranged close enough to prevent a thin base 17 from drooping. Every second of the conveyor rollers 16A or, alternatively, all of them are coupled to a driving source as occasion demands.

The base 17 is carried by the conveyor rollers 16A and conveyed while held in position by the pressing rollers 16B. Like the conveyor rollers 16A the pressing rollers 16B, which are also rotatably fitted to the frame 20, may be formed as columnar members to keep a thin base 17 from warning and waring and thus from being caught by any rotary means.

Although the pressing rollers 16B normally are not coupled to the driving source, they may be coupled thereto. When a base 17 is used which is not thin and tends to less warp and wave, the pressing rollers 16B may consist of a plurality of discoidal members.

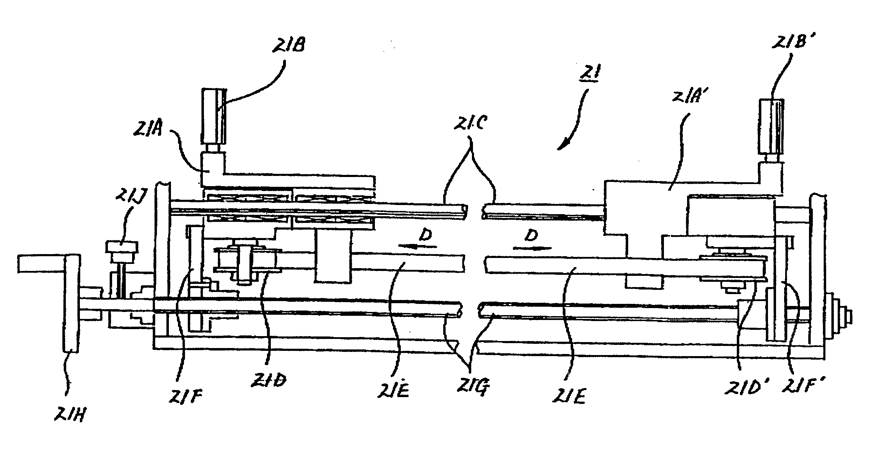

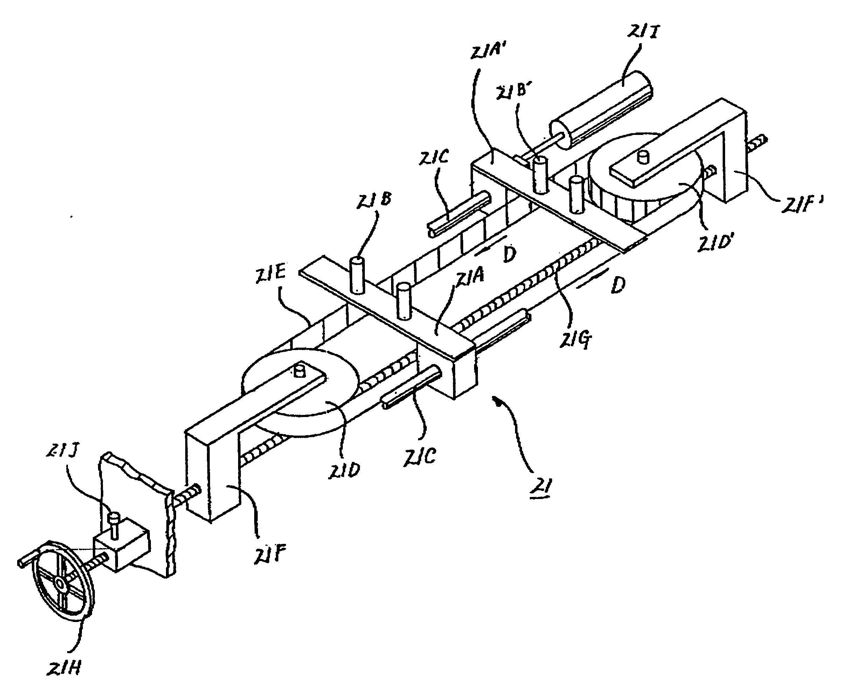

As shown in fig. 3 (sectional view taken along line Y-Y of Fig. 1) and Fig. 4 (perspective view), a crosswise base guide 21 comprises crosswise base guide members 21B, 21B' supported by support members 21A, 21A'. The support members 21A, 21A' are slidably fitted to a support rod 21C and attacked to an endless belt 21E wound on pulleys 21D, 21D' in such a manner that they are moved towards each other when the endless belt 21E moves in the direction of arrow D. The sopport members 21A, 21A' are caused to slide along the support rod 21C by an air cylinder 21I installed on the support member 21A'.

The pulleys 21D, 21D' are supported by inverted L-shaped support members 21F, 21F', respectively. The inverted L-shaped support members 21F, 21F' mate with a threaded rod 21G, which is equipped with a handle 21H and, by turning the handle 21H, the inverted L-shaped support members 21F, 21F' are transversely moved while a fixed distance is maintained therebetween. This moving mechanism is intended to adjust the position of the crosswise base guide 21 to make the centerline in the conveyance direction of the base 17 coincide with the centerline in the conveyance direction of the laminate 1B for thermocompression bonding, i.e. the centerline of the apparatus 16 in case the former shifts from the latter. The position of the crosswise base guide 21 can be fixed by a screw 21J for preventing rotation of the threaded rod 21G.

A base position detecting sensor 22 (Fig. 1) for detecting the front (or rear) end of a base 17 produces a signal for starting driving the crosswise base guide members 21B, 21B' of the crosswise base guide 21 towards each other. The base position detecting sensor 22 is fitted to the frame 20 through a support frame 22A. A reflective optical sensor is, for instance, employed as the base position detecting sensor 22.

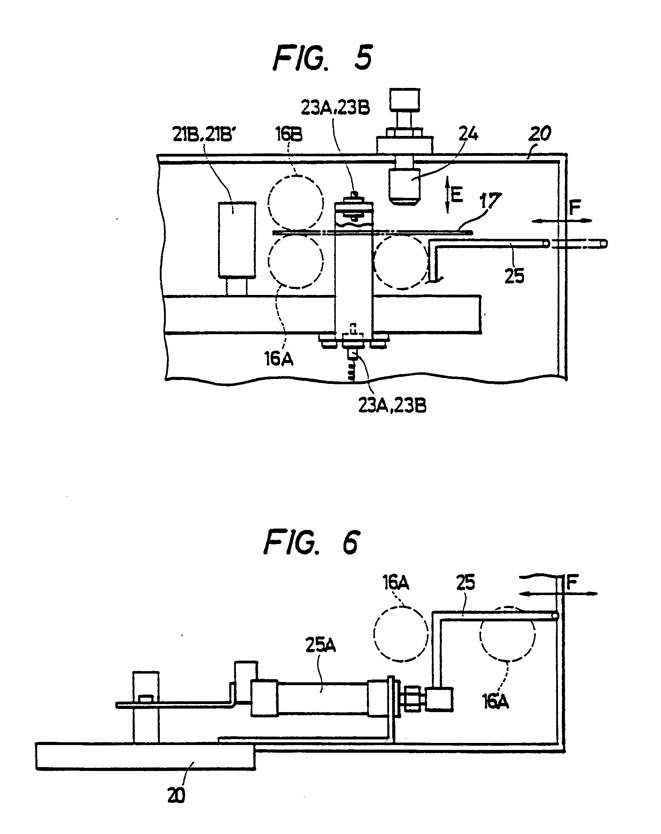

Base breadth detecting sensors 23A, 23B (Figs. 1 and 5) for respectively detecting both sides of the base 17 produce signals for stopping driving the crosswise base guide members 21B, 21B' towards each other. The base breadth detecting sensors 23A, 23B are installed on the inner sides of the crosswise base guide members 21B, 21B' close to the front end in the conveyance direction of the support members 21A, 21A'. In other words, the base breadth detecting sensors 23A, 23B are installed in such a position as to stop the crosswise base guide members 21B, 21B' when the centerline of the base 17 coincides with the centerline of the apparatus 16. The control of the crosswise base guide 21 can simply be materialized by causing the signal for stopping drive of the crosswise base guide members 21B, 21B' to be produced slightly after the time when both sides of the base 17 have been detected by the base breadth detecting sensors 23A, 23B using a delay circuit. As the base breadth detecting sensors 23A, 23B, translucent type optical sensors can be used.

The base 17 can thus be conveyed to the starting position of thermocompression bonding readily and accurately in such a state that the centerline in the conveyance direction of the base 17 is made to coincide with the centerline in the conveyance direction of the apparatus 16 without allowing the base 17 to bend.

A base holding member 24 shown in Figs. 1 and 5 fixes and holds the base 17 so that it may not drop when it reaches the starting position of the thermocompression bonding. The base holding member 24 is fitted to the frame 20 and moved by an air cylinder and a spring (not shown) in the direction of arrow E. Additionaly, a base support member 25 can be projected in the direction of arrow F interlockingly or not interlockingly with the operation of the base holding member 24. Control of the base support member 25 in the direction of arrow E is achieved by an air cylinder 25A (Fig. 6) fitted to the frame 20. The operation of the base holding member 24 and or the base support member 25 is likewise controlled by the signal obtained from the base position detecting sensor 22.

The base holding member 24 and the base support member 25 thus installed support the base 17 to prevent it from dropping when it reaches the starting position of the thermocompression bonding and are capable of holding it in position until the thermocompression rollers vertically clamp it therebetween, so that the laminate 1B is accurately bonded onto the base 17.

As a modification, in order to control operation of the crosswise base guide 21 for causing the centerline of the base 17 to coincide with the centerline of the laminate 1B to be bonded to the base, breadth detecting sensors (not shown) for detecting the breadth of the laminate may be provided at a predetermined position on each of the upper and lower laminate supply paths. In this case, the detection signals of these sensors 23A, 23B are inputted into a well known controller (not shown) whereby the upper and lower laminates 1B are brought positioned into alignment with each other in accordance with the control signals (soft ware). Similarly by controlling the drive means of the crosswise base guide 21, the centerline of the crosswise base guide is made to coincide with the centerline of the laminates 1B.

Operation of the apparatus 16 will now briefly be described :

A base 17 is conveyed toward the thermocompression rollers 14 by driving the respective conveyor rollers 16A. When the front end of the base 17 thus conveyed is detected by the base position detecting sensor 22, the signal therefrom starts operation of the crosswise base guide 21. When both sides of the base 17 are then detected by the base breadth detecting sensors 23A, 23B, the operation of the crosswise base guide 21 is stopped. The base 17 is consequently conveyed to the position of thermocompression bonding in such a state that its centerline in the conveyance direction coincides with the centerline in the conveyance direction of the apparatus 16. Then the conveyor rollers 16A are stopped and the holding member 24 moves down and makes the base immovable. The base support member 25 simultaneously projects to support the base and prevent it from dropping. Then, as shown in Fig. 2, the thermocompression rollers 14 move to the left and clamp the base inclusive the laminate or laminates 1B for thermocompression bonding.

Further, only one of the crosswise base guide members 21B and 21B' may be made to move though it is preferred to move both of them. In this case only one side of the base 17 in the crosswise direction may be detected.

In the foregoing embodiment, in order to corect the positional offset between the base and the thin films or laminates 1B to be laminated thereon by means of the crosswise base guide 21, the set positions of the upper and lower thin films or laminates 1B may be detected for automatic aligning. As a variation the set position of the upper or lower thin film or laminate may be held satationary whereas the other one is adjustable.

## Claims

1. An apparatus (16) for conveying a base (17) as of a printed circuit board along a conveying path comprising :
- a crosswise base guide (21) for making the center line of said base (17) in the conveyance direction coincide with an external other center line, said crosswise base guide including mutually approachable guide members (21B, 21B') on either side of said conveying path,
- base position detecting sensor means (22) for starting movement of said guide members (21B, 21B') towards each other from an initial relatively spaced position upon detection of said base (17) in a predetermined position along said conveying path, and
- base breadth detecting sensor means (23A, 23B) for stopping movement of said guide members (21B, 21B') upon reaching a distance corresponding to the breadth of said base (17).

2. The apparatus of claim 1 wherein said external other center line is a center line in the conveyance direction of the apparatus (16) itself.

3. The apparatus of claim 1 coupled to a laminator (I) for bonding a film (1B) onto said base (17) wherein said external center line is that one of said film.

4. The apparatus of anyone of the preceding claims wherein said base position detecting sensor means (22) is disposed upstream of said base breadth detecting sensor means (23A, 23B) in the conveying direction.

5. The apparatus of anyone of the preceding claims wherein said base position detecting sensor means (22) is adapted to detect either the leading end or the trailing end of said base (17).

6. The apparatus of anyone of the preceding claims wherein said base breadth detecting sensor means (23A, 23B) is adapted to detect at least one of the sides of said base (17).

7. The apparatus of anyone of the preceding claims wherein said sensor means (22, 23A, 23B) comprise optical sensors.

8. The apparatus of anyone of the preceding claims wherein said crosswise base guide (21) further comprises :
- a support rod (21C) extending generally perpendicular to the conveying direction in a plane generally parallel to the plane of said base (17) in said conveying path,
- a pulley (21D, 21D') rotatably mounted on either side of said crosswise base guide (21) with regard to said center lines,
- an endless belt (21E) entrained between said pulleys (21D, 21D'), and
- a pair of guide member supports (21A, 21A') carrying one of said guide members (21B, 21B') each and being slidably mounted on said support rod (21C) and connected on opposite sides to said endless belt (21E) so that said guide member supports move towards or away from one another as said endless belt is moved.

9. The apparatus of claim 8 further comprising an air cylinder (21I) connected to one of said guide member supports (21A, 21A') for moving both said guide member supports simultaneously through movement of said endless belt (21E).

10. The apparatus of anyone of the preceding claims further comprising base guide moving means (21F, 21F', 21G, 21H) for shifting said crosswise base guide (21) as a whole crosswise with respect to the conveying direction.

11. The apparatus of the claims 8 and 10 wherein said base guide moving means comprises :
- a threaded rod (21G) extending generally parallel to said support rod (21C), and
- first and second pulley support members (21F, 21F') carrying one of said pulleys (21D, 21D') each and being threadedly engaged with said threaded rod (21G) to move jointly in the same direction crosswise to said conveying direction when said threaded rod is rotated.

12. The apparatus of claim 11 further comprising manual rotating means (21H) for said threaded rod (21G).

13. The apparatus of anyone of the preceding claims wherein said base (17) is conveyed to a predetermined clamping position, the apparatus further comprising :
- a base holding member (24) for arresting said base (17) in a position immediately ahead of said clamping position, and
- a base support member (25) movable in said conveying direction for receiving and feeding said base (17) from said arresting position to said clamping position when said holding member (24) has been released.

14. The apparatus of claim 13 wherein said base holding member (24) is mounted above said conveying path ahead of said clamping position and movable perpendicular to the plane of said path.

15. The apparatus of claim 13 or 14 wherein said base supporting member (25) is arranged for supporting said base (17) from below and coupled to an air cylinder (25A) for movement in said conveying direction.

16. The apparatus of anyone of the claims 13 to 15 wherein also said base holding member (24) and said base support member (25) are automatically controlled by means of signals obtained from sensor means arranged along said conveying path.

## Ansprüche

1. Vorrichtung (16) zum Befördern einer Basis (17) wie einer gedruckten Schaltungsplatte entlang einer Förderbahn mit

– einer Basisquerführung (21) zur Herstellung von Koinzidenz zwischen der Mittellinie der Basis (17) in der Förderrichtung mit einer externen anderen Mittellinie, wobei die Basisquerführung aneinander annäherbare Führungsglieder (21B, 21B') zu beiden Seiten der Förderbahn enthält,

– die Basisposition feststellenden Abtastmitteln (22) zur Einleitung einer Bewegung dieser Führungsglieder (21B, 21B') gegeneinander aus einem ursprünglichen verhältnismäßig großen Abstand nach Feststellung der Basis (17) in einer vorbestimmten Position entlang der Förderbahn und

– die Basisbreite feststellenden Abtastmitteln (23A, 23B) zum Abbrechen der Bewegung der Führungsglieder (21B, 21B') nach Erreichen einer Entfernung entsprechend der Breite der Basis (17).

2. Vorrichtung nach Anspruch 1, worin die externe andere Mittellinie eine in der Förderrichtung verlaufende Mittellinie der Vorrichtung (16) selbst ist.

3. Vorrichtung nach Anspruch 1 gekuppelt an einen Laminator (I) zum Auflaminieren eines Filmes (1B) auf die Basis (17), worin die externe Mittellinie diejenige des Filmes ist.

4. Vorrichtung nach einem der vorhergehenden Ansprüche, worin die die Basisposition festellenden Abtastmittel (22) in bezug auf die Förderrichtung oberhalb der die Basisbreite feststellenden Abtastmittel (23A, 23B) angeordnet sind.

5. Vorrichtung nach einem der vorhergehenden Ansprüche, worin die die Basisposition feststellenden Abtastmittel (22) in der Lage sind, entweder das Führungsende oder das rückwärtige Ende der Basis (17) festzustellen.

6. Vorrichtung nach einem der vorhergehenden Ansprüche, worin die die Basisbreite feststellenden Abtastmittel (23A, 23B) in der Lage sind, zumindest eine der Seiten der Basis (17) festzustellen.

7. Vorrichtung nach einem der vorhergehenden Ansprüche, worin die genannten Abtastmittel (22, 23A, 23B) optische Sensoren aufweisen.

8. Vorrichtung nach einem der vorhergehenden Ansprüche, worin die Basisquerführung (21) des weiteren umfaßt :

– eine Tragstange (21C), die sich im wesentlichen senkrecht zu der Förderrichtung in einer Ebene im wesentlichen parallel zu der Ebene der Basis (17) in der Förderbahn erstreckt,

– eine auf einer jeden Seite der Basisquerführung (21) in bezug auf die Mittellinie drehbar angebrachte Umlenkscheibe (21D, 21D'),

– einen zwischen den Umlenkscheiben (21D, 21D') verlaufenden endlosen Riemen (21E) und

– ein Paar Führungsglied-Auflager (21A, 21A'), die je eines der genannten Führungsglieder (21B, 21B') tragen und auf der Tragstange (21C) gleitfähig gelagert und auf gegenüberliegenden Seiten mit dem endlosen Riemen (21E) verbunden sind, so daß die Führungsglied-Auflager sich bei Bewegung des endlosen Riemens gegeneinander oder voneinander weg bewegen.

9. Vorrichtung nach Anspruch 8, des weiteren enthaltend einen Luftzylinder (21I) in Verbindung mit einem der Führungsglied-Auflager (21A, 21A') zum gleichzeitigen Bewegen der beiden Führungsglied-Auflager durch Bewegung des endlosen Riemens (21E).

10. Vorrichtung nach einem der vorhergehenden Ansprüche, des weiteren enthaltend Basisführungs-Antriebsmittel (21F, 21F', 21G, 21H) zum Verlagern der Basisquerführung (21) als ganzes quer zu der Förderrichtung.

11. Vorrichtung nach den Ansprüchen 8 und 10, worin die Basisführungs-Antriebsmittel enthalten :

– eine Gewindespindel (21G), die sich im wesentlichen parallel zu der Tragstange (21C) erstreckt, und

– erste und zweite Umlenkscheiben-Lagerglieder (21F, 21F'), deren jedes eine der Umlenkscheiben (21D, 21D') trägt und in Gewindeeingriff mit der Gewindespindel (21G) steht, um sich gemeinsam in der gleichen Richtung quer zu der Förderrichtung zu bewegen, wenn die Gewindespindel gedreht wird.

12. Vorrichtung nach Anspruch 11, des weiteren enthaltend manuelle Drehmittel (21H) für die Gewindespindel (21G).

13. Vorrichtung nach einem der vorhergehenden Ansprüche, bei der die Basis (17) in eine vorbestimmte Klemmposition befördert wird, wobei die Vorrichtung des weiteren enthält :

– ein Basishalteglied (24) zum Festhalten der Basis (17) in einer Position unmittelbar vor der Klemmposition und

– ein in der Förderrichtung bewegliches Basisstragglied (25) zum Aufnehmen und Weitergeben der Basis (17) aus der Halteposition in die Klemmposition, wenn das Halteglied (24) freigegeben worden ist.

14. Vorrichtung nach Anspruch 13, worin das Basishalteglied (24) über der Förderbahn vor der Klemmposition angeordnet und senkrecht zu der Ebene der Förderbahn beweglich ist.

15. Vorrichtung nach Anspruch 13 oder 14, worin das Basistragglied (25) dazu ausgebildet ist, die Basis (17) von unten her zu tragen, und mit einem Luftzylinder (25A) verbunden ist zum Bewegen in der Förderrichtung.

16. Vorrichtung nach einem der Ansprüche 13 bis 15, worin auch das Basishalteglied (24) und das Basistragglied (25) durch Signale aus den entlang der Förderbahn angeordneten Abtastmitteln automatisch gesteuert sind.

## Revendications

1. Appareil (16) de transport d'une base (17) constituant une carte de circuit imprimé, le long d'un trajet de transport, comprenant :

– un guide transversal (21) de base destiné à mettre en coïncidence l'axe central de la base (17) dans la direction de transport avec un autre axe central externe, le guide transversal de la base comprenant des organes (21B, 21B') de guidage qui peuvent se rapprocher, de part et d'autre du trajet de transport,

– un capteur (22) de détection de position de base destiné à déclencher le déplacement des organes de guidage (21B, 21B') l'un vers l'autre, à partir d'une position initiale relativement espacée, à la suite de la détection du fait que la base (17) se trouve dans une position prédéterminée le long du trajet de transport, et

– un capteur (23A, 23B) de détection de largeur de base destiné à interrompre le déplacement des organes de guidage (21B, 21B') lorsqu'une distance correspondant à la largeur de la base (17) a été atteinte.

2. Appareil selon la revendication 1, dans lequel l'autre axe central externe est un axe central orienté dans la direction de transport de l'appareil (16) lui-même.

3. Appareil selon la revendication 1, couplé à un organe de stratification (I) destiné à coller un film (1B) sur la base (17), l'axe central externe étant celui du film.

4. Appareil selon l'une quelconque des revendications précédentes, dans lequel le capteur (22) de détection de la position de base est placé en amont du capteur (23A, 23B) de détection de largeur de base, dans la direction de transport.

5. Appareil selon l'une quelconque des revendications précédentes, dans lequel le capteur (22) de détection de la position de base est destiné à détecter le bord antérieur ou le bord postérieur de la base (17).

6. Appareil selon l'une quelconque des revendications précédentes, dans lequel le capteur (23A, 23B) de détection de la largeur de la base est destiné à détecter au moins L'un des côtés de la base (17).

7. Appareil selon l'une quelconque des revendications précédentes, dans lequel les capteurs (22, 23A, 23B) sont des capteurs optiques.

8. Appareil selon l'une quelconque des revendications précédentes, dans lequel le guide transversal (21) de base comporte en outre :

– une tige de support (21C) disposée de façon générale en direction perpendiculaire à la direction de transport, dans un plan parallèle de façon générale au plan de la base (17) sur le trajet de transport,

– une poulie (21D, 21D') montée afin qu'elle puisse tourner de part et d'autre du guide transversal (21), par rapport aux axes centraux,

– une courroie sans fin (21E) entraînée entre les poulies (21D, 21D'), et

– deux supports (21A, 21A') d'organe de guidage portant l'un des organes de guidage (21B, 21B'), chacun pouvant coulisser sur la tige de support (21C) sur laquelle il est monté, et étant raccordés de part et d'autre à la courroie sans fin (21E) afin que les supports d'organe de guidage se déplacent l'un vers l'autre ou à distance l'un de l'autre lorsque la courroie sans fin se déplace.

9. Appareil selon la revendication 8, comprenant en outre un vérin pneumatique (21I) raccordé à l'un des supports (21A, 21A') d'organe de guidage et destiné à déplacer les supports simultanément par déplacement de la courroie sans fin (21E).

10. Appareil selon l'une quelconque des revendications précédentes, comprenant en outre un dispositif (21F, 21F', 21G, 21H) de déplacement du guide de base destiné à déplacer le guide transversal (21) de base comme un tout transversalement par rapport à la direction de transport.

11. Appareil selon les revendications 8 et 10, dans lequel le dispositif de déplacement du guide de base comporte :

– une tige filetée (21G) disposée parallèlement de façon générale à la tige de support (21C), et

– un premier et un second organe de support (21F, 21F') de poulie portant l'une des poulies (21D, 21D'), chacun coopérant par vissage avec la tige filetée (21G) afin qu'ils se déplacent ensemble dans le même sens transversalement à la direction de transport lorsque la tige filetée tourne.

12. Appareil selon la revendication 11, comprenant en outre un dispositif manuel (21H) d'entraînement en rotation de la tige filetée (21G).

13. Appareil selon l'une quelconque des revendications précédentes, dans lequel la base (17) est transportée à une position prédéterminée de serrage, l'appareil comprenant en outre :

– un organe de maintien de base (24) destiné à arrêter la base (17) en position qui se trouve juste en amont de la position de serrage, et

– un organe de support de base (25) mobile dans la direction de transport destiné à recevoir et faire avancer la base (17) depuis la position d'arrêt vers la position de serrage lorsque l'organe de maintien (24) a été libéré.

14. Appareil selon la revendication 13, dans lequel l'organe de maintien de base (24) est monté au-dessus du trajet de transport en amont de la position de serrage et est mobile perpendiculairement au plan du trajet.

15. Appareil selon la revendication 13 ou 14, dans lequel l'organe de support de base (25) est disposé afin qu'il supporte la base (17) par-dessous et est couplé à un vérin pneumatique (25A) destiné à se déplacer dans la direction de transport.

16. Appareil selon l'une quelconque des revendications 13 à 15, dans lequel l'organe de maintien de base (24) et l'organe de support de base (25) sont aussi commandés automatiquement à l'aide de signaux obtenus à partir de capteurs placés le long du trajet de transport.

# FIG. 2

## FIG. 5

## FIG. 6